# EUROPÄISCHE PATENTSCHRIFT

(11) **EP 2 210 356 B1**
(45) Veröffentlichungstag und Bekanntmachung des Hinweises auf die Patenterteilung: **23.03.2011**
(21) Anmeldenummer: 08802858.4
(22) Anmeldetag: 10.10.2008
(51) Int. Cl.: H04J 3/06, H04L 7/02

(54) **VERFAHREN UND VORRICHTUNG ZUR VERMEIDUNG VON SCHWANKUNGEN EINES DIGITAL ERZEUGTEN AUSGABETAKTS**
METHOD AND APPARATUS FOR PREVENTING FLUCTUATIONS IN A DIGITALLY PRODUCED OUTPUT CLOCK SIGNAL
PROCÉDÉ ET DISPOSITIF POUR ÉVITER LES VARIATIONS D'UNE CADENCE DE SORTIE PRODUITE PAR VOIE NUMÉRIQUE

(30) Priorität: 12.11.2007 DE 102007053795
(43) Veröffentlichungstag der Anmeldung: 28.07.2010
(73) Patentinhaber: Rohde & Schwarz GmbH & Co. KG, 81671 München (DE)
(72) Erfinder: MEIER, Niclas, 82140 Olching (DE); BALZ, Christoph, 81543 München (DE)
(74) Vertreter: Körfer, Thomas
(86) Internationale Anmeldenummer: PCT/EP2008/008585
(87) Internationale Veröffentlichungsnummer: WO 2009/062574

(56) Entgegenhaltungen:
- EP-A- 0 565 305
- EP-A- 0 915 587
- EP-A- 1 455 473
- WO-A-01/37468
- WO-A-02/091642

## Beschreibung

Die Erfindung betrifft ein Verfahren und eine Vorrichtung zur Vermeidung von Schwankungen eines digital erzeugten Ausgabetakts, insbesondere bei schwankender Frequenz von Empfangssignalen in digitalen Kommunikationseinrichtungen.

Herkömmlich werden zur Anpassung des Ausgabetaktes in Kommunikationssystemen Informationen aus der jeweiligen Protokollebene herangezogen. So sind der Füllstand eines Puffers aber auch die Phasendifferenz der Signale übliche Parameter anhand derer die Frequenz des Ausgabetaktes geregelt wird.

So wird in der US 6,252,850 B1 ein Verfahren und eine Vorrichtung zur adaptiven Taktrückgewinnung gezeigt. Dabei werden als Parameter zur Regelung des Ausgabetakts die Füllstände zweier Puffer herangezogen. Parameter, welche anderen Protokollebenen entstammen, werden nicht genutzt.

Das Dokument EP 1 455 473 A offenbart ein Verfahren zur Vermeidung von Schwankungen. Dabei wird ein digitales Signal mit einem Eingabetakt empfangen und in einem Puffer gespeichert. Es wird mit einem Ausgabetakt wieder aus dem Puffer gelesen und ausgegeben. Der Füllstand des Puffers wird dabei zur Regelung der Frequenz des Ausgangssignals herangezogen. Eine zusätzliche Störgröße wird dabei benutzt um eine Vorkompensation des Ausgabetakts durchzuführen.

Auch das Dokument WP 02/091642 A2 offenbart ein Verfahren zur Vermeidung von Schwankungen. Ein empfangenes Signal wird in einem Puffer gespeichert. Auch hier wird der Stand des Puffers als Regelgröße der Frequenz eines ausgesendeten Signals genutzt.

Das Dokument EP 0 915 587 A2 zeigt ebenfalls ein Verfahren und eine Vorrichtung zum schwankungsfreien Aussenden von Signalen. Ein in einem Puffer gespeichertes empfangenes Signal wird erneut ausgesendet. Der Füllstand des Puffers wird auch hier zur Regelung eines Ausgabetakts herangezogen.

Die bisher gebräuchlichen Verfahren und Vorrichtungen sind nachteilhaft, da die Einschwingzeit und Stabilität der Regelung und die Schwankungen des Takts lediglich suboptimale Werte erreichen. Für bestimmte Kommunikationsvorgänge sind die erreichten Werte nicht ausreichend.

Der Erfindung liegt die Aufgabe zu Grunde, ein Verfahren und eine Vorrichtung zu schaffen, welche ein hohes Maß an Stabilität des Ausgabetakts bei gleichzeitig geringem Verarbeitungsaufwand und geringem Aufwand des Geräteaufbaus ermöglichen.

Die Aufgabe wird erfindungsgemäß für das Verfahren durch die Merkmale des unabhängigen Anspruchs 1 und für die Vorrichtung durch die Merkmale des unabhängigen Anspruchs 5 gelöst. Vorteilhafte Weiterbildungen sind Gegenstand der hierauf rückbezogenen Unteransprüche.

Eine Vorrichtung zur Vermeidung von Schwankungen eines digital erzeugten Ausgabetakts beinhaltet einen digitalen Taktgenerator, einen Puffer, eine Füllstands-Mess-Einrichtung und einen Regler. Der Puffer speichert ein mit einem Eingabetakt empfangenes digitales Signal und gibt es mit einem Ausgabetakt aus. Die Füllstands-Mess-Einrichtung misst den Füllstand des Puffers. Der Regler nutzt den Füllstand des Puffers zur Regelung der Frequenz des digital erzeugten Ausgabetaktes. Die Abweichung des Eingabetakts von dem Ausgabetakt ist die Störgröße der Regelung. Die Vorrichtung enthält weiterhin eine Kompensations-Einrichtung, welche eine zusätzliche Grobschätzung der Störgröße der Regelung durchführt und zur Vorkompensation des Ausgabetakts nutzt. Das digitale Signal wird aus einem analogen Übertragungssignal gewonnen. Das analoge Übertragungssignal wird zur Gewinnung des digitalen Signals demoduliert und decodiert. Die Kompensations-Einrichtung bestimmt die Grobschätzwerte der Störgröße der Regelung aus Parametern, welche aus der Demodulation und/oder Decodierung des analogen Übertragungssignals gewonnen werden. So ist eine deutliche Reduzierung der Schwankungen des Ausgabetakts gewährleistet. Gleichzeitig wird die Einschwingzeit des Reglers signifikant reduziert. Ein weiter Fangbereich der Regelung ist ebenfalls gegeben. Diese Schätzwerte ermöglichen eine genau Schätzung der Störgröße und damit eine kurze Einschwingzeit des Reglers und eine minimale Schwankung des Ausgabetakts. Eine aufwandsarme Gewinnung der Schätzwerte ist so gegeben.

Demodulation und/oder Decodierung des analogen Übertragungssignals gewonnen werden. Diese Schätzwerte ermöglichen eine genau Schätzung der Störgröße und damit eine kurze Einschwingzeit des Reglers und eine minimale Schwankung des Ausgabetakts. Eine aufwandsarme Gewinnung der Schätzwerte ist so gegeben.

Vorteilhafterweise enthält die Vorrichtung weiterhin einen Begrenzer. Der Begrenzer begrenzt vorzugsweise den Wert der Änderung des Ausgabetakts durch die Regelung innerhalb eines Regelungsschritts auf einen Maximalwert, wobei der Maximalwert bevorzugt einstellbar ist. So wird die Schwankung des Ausgabetakts weiterhin reduziert. Gleichzeitig steigt jedoch die Einschwingzeit des Reglers.

Vorteilhafterweise misst die Füllstands-Mess-Einrichtung den Füllstand des Puffers nicht in jedem Regelungsschritt. Einerseits ist der Messaufwand so reduziert. Andererseits ist ein aussagekräftiges Ergebnis der Messung nur zu bestimmten Zeitpunkten gegeben, da das eintreffende digitale Signal in Signal-Bursts, welche nicht mit dem Regelungszyklus synchronisiert sind eintrifft. Damit ist ein aussagekräftiges Ergebnis der Füllstandsmessung lediglich zu Zeitpunkten, welche durch Multiplizierung der Zyklusdauern der Bursts und der Regelung gegeben sind, erhältlich.

Die Vorrichtung enthält bevorzugt weiterhin einen Speicher. Vorteilhafterweise wird das digitale Eingangssignal mit einem aus einer Mehrzahl von Kommunikationsmodi übertragen. Der Speicher hält bevorzugt für jeden möglichen Kommunikationsmodus einen Eingabetakt und eines Startwert der Regelung für den Ausgabetakt bereit. Der Speicher überträgt bevorzugt bei Empfang eines Signals, welches einen bestimmten Kommunikationsmodus anzeigt, den gespeicherten Eingabetakt an die Kompensations-Einrichtung und den gespeicherten Startwert der Regelung des Ausgabetakts an den Taktgenerator. So ist ein Einsatz in einem weiten Feld an Übertragungsmodi möglich. Weiterhin ist ein schnelles Einschwingen der Regelung gegeben, da als Startwerte Werte nahe dem eingeschwungenen Wert genutzt werden.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: ein erstes Blockschaltbild eines Ausführungsbeispiels der erfindungsgemäßen Vorrichtung;
- Fig. 2: ein zweites Blockschaltbild eines Ausführungsbeispiels der erfindungsgemäßen Vorrichtung;
- Fig. 3: beispielhafte Verläufe der Füllstandsabweichung ohne Vorkompensation des Ausgabetakts;
- Fig. 4: beispielhafte Verläufe der Füllstandsabweichung mit Vorkompensation des Ausgabetakts;
- Fig. 5: beispielhafte Schwankungen des Ausgabetaktes bei hohem Schätzfehler;
- Fig. 6: beispielhafte Schwankungen des Ausgabetaktes bei mittlerem Schätzfehler, und
- Fig. 7: beispielhafte Schwankungen des Ausgabetaktes bei geringem Schätzfehler.

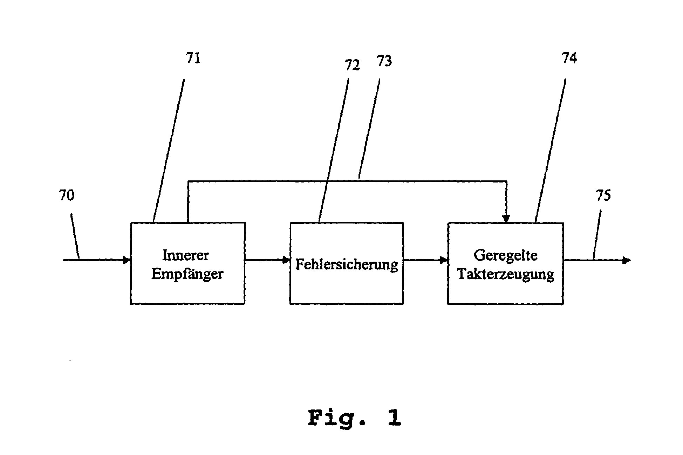

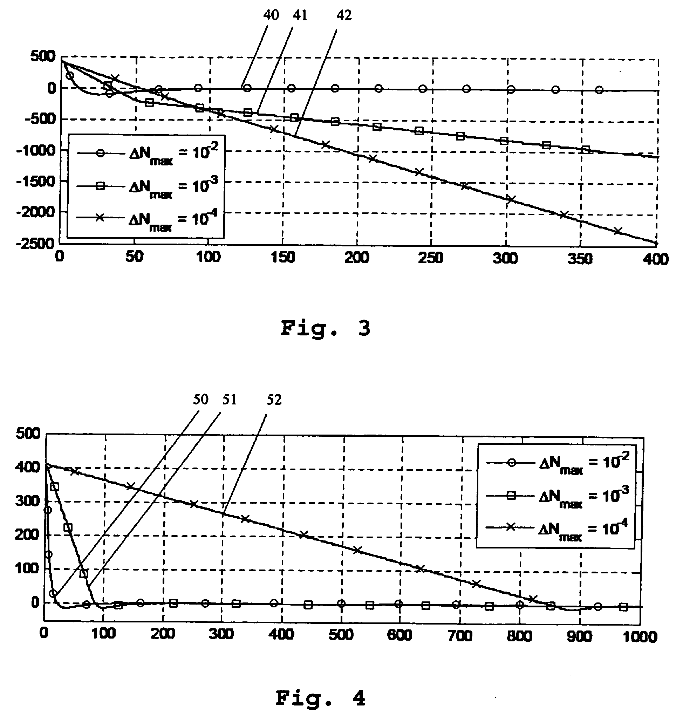

Zunächst wird anhand der Fig. 1 - 2 der Aufbau und die Funktionsweise der erfindungsgemäßen Vorrichtung und des erfindungsgemäßen Verfahrens gezeigt. Mittels Fig. 3 - 7 wird die Funktionsweise anhand von Messergebnissen weiter erläutert. Identische Elemente werden in ähnlichen Abbildungen zum Teil nicht wiederholt dargestellt und beschrieben.

In Fig. 1 wird ein erstes Blockschaltbild eines Ausführungsbeispiels der erfindungsgemäßen Vorrichtung dargestellt. Ein innerer Empfänger 71 ist mit einer Fehlersicherungs-Einrichtung 72 verbunden. Die Fehlersicherungs-Einrichtung 72 ist mit einer geregelten Takterzeugungs-Einrichtung 73 verbunden. Weiterhin ist der innere Empfänger 71 mit der geregelten Takterzeugungs-Einrichtung 73 verbunden. Ein empfangenes Signal 70 mit einem Eingabetakt wird von dem inneren Empfänger 71 demoduliert. Dabei werden Parameter 73, welche eine Schätzung des Eingabetakts ermöglichen, an die geregelte Takterzeugung 74 weitergeleitet. Das demodulierte Signal wird an die Fehlersicherungs-Einrichtung 72 weitergeleitet. Diese decodiert das demodulierte Signal. Dies geschieht z.B. durch einen Reed-Solomon-Decoder.

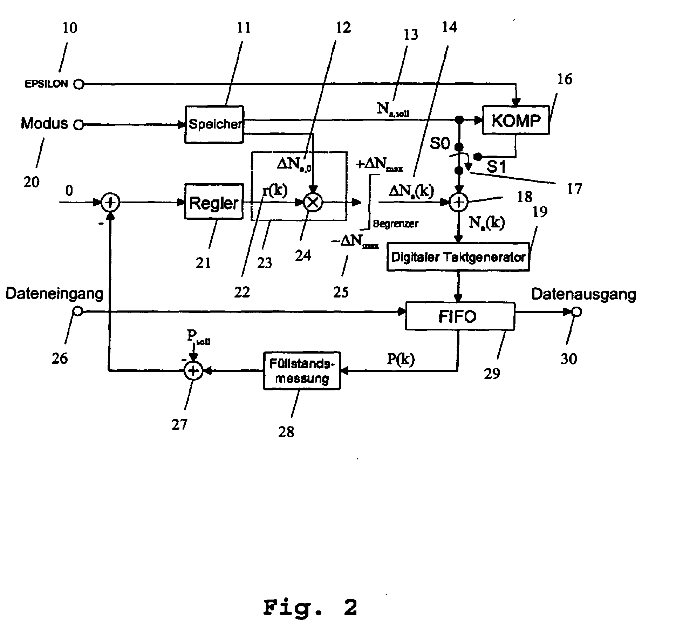

Die geregelte Takterzeugungs-Einrichtung 73 nimmt das Signal mit einem ihr unbekannten Eingabetakt, welcher weitgehend dem Eingabetakt des empfangenen Signals 70 entspricht, entgegen. Sie erzeugt einen Ausgabetakt, der möglichst genau dem Eingabetakt entspricht, vermindert dabei jedoch durch Pufferung soweit möglich Schwankungen des Eingabetakts im Ausgabetakt. Hierzu werden die Parameter 73 des inneren Empfängers 71 genutzt. Dieser Vorgang wird anhand der Fig. 2 näher beschrieben.

Fig. 2 zeigt ein zweites Blockschaltbild eines Ausführungsbeispiels der erfindungsgemäßen Vorrichtung. Hier wird die Funktion der geregelten Takterzeugungs-Einrichtung 74 aus Fig. 1 näher erläutert. Ein Dateneingang 26 ist mit einem Puffer 29 verbunden. Der Puffer 29 arbeitet nach dem "first in first out" Prinzip. D.h. zuerst eingegebene Daten werden zuerst ausgegeben. Der Puffer ist mit einem Datenausgang 30 verbunden.

Der Puffer ist weiterhin mit der Füllstands-Mess-Einrichtung 28 verbunden. Diese ist mit einem Addierer 27 und darüber mit einem Regler 21 verbunden. Ein weiterer Eingang 20 ist mit einem Speicher 11 und über diesen mit einem Multiplizierer 24 verbunden. Der Regler 21 ist ebenfalls mit dem Multiplizierer 24 verbunden. Der Multiplizierer ist mit einem Begrenzer 25 verbunden, der wiederum mit einem Addierer 18 verbunden ist. Ein weiterer Eingang 10 ist mit einer Kompensations-Einrichtung 16 und über den Schalter 17 mit dem Addierer 18 verbunden. Der Speicher 11 ist ebenfalls über den Schalter 17 mit dem Addierer verbunden. Der Addierer 18 ist mit einem digitalen Taktgenerator 19 verbunden.

Über den Dateneingang 26 werden die demodulierten und decodierten Daten mit einem Eingabetakt eingegeben. Der Puffer 29 speichert die Daten in der Reihenfolge ihres Eintreffens. Über den Datenausgang 30 werden die Daten mit einem Ausgabetakt ausgegeben. Der Ausgabetakt wird von dem digitalen Taktgenerator 19 erzeugt. Der Füllstand des Puffers 29 wird von der Füllstands-Mess-Einrichtung 28 ermittelt. Von dem Addierer 27 wird der Soll-Füllstand P_{Soll} subtrahiert. Das Vorzeichen des erhaltenen Werts wird invertiert. Das Resultat wird in den Regler 21 eingegeben. Der Regler 21 gibt daraufhin die Stellgröße r(k) 22 aus. Die Stellgröße ist dabei lediglich eine normierte Größe. Sie wird in dem Multiplizierer 24 mit einem Proportionalitätsfaktor ΔN_{a,0} 12 multipliziert.

Über den weiteren Eingang 20 wird der jeweilige Kommunikationsmodus signalisiert. Dies beinhaltet unter anderem die Datenrate der Übertragung. Zu jedem möglichen Kommunikationsmodus ist in dem Speicher 11 ein Proportionalitätsfaktor ΔN_{a,0} 12 gespeichert, der an den Multiplizierer 24 übertragen wird. Der Multiplizierer gibt somit eine zu dem Proportionalitätsfaktor ΔN_{a,0} 12 und der Stellgröße r(k) 22 proportionale Größe aus. Diese Größe wird von dem Begrenzer 25 auf einen Maximalwert +ΔNₘₐₓ und einen Minimalwert +ΔNₘᵢₙ begrenzt. Die resultierende Größe ΔNₐ(k) 14 wird an den Addierer 18 geleitet.

Befindet sich der Schalters 17 in der Position S0, so ist die erfindungsgemäße Regelung abgeschaltet. Befindet er sich in der Position S0, so ist die erfindungsgemäße Regelung aktiviert. Da der Puffer 29 beim Einschalten der Regelung noch nicht über einen aussagekräftigen Füllstand verfügt, wird bis zum Erreichen eines solchen Füllstandes die Ausgabe 14 des Begrenzers 25 unterdrückt und nicht im Addierer 18 auf eine, aus dem Speicher 11 ausgelesene Soll-Ausgabetakt-Frequenz N_{a,soll} addiert. Sobald der Puffer 29 ausreichend mit Daten gefüllt ist, wird die Ausgabe 14 des Puffers 25 nicht länger unterdrückt und damit die Regelung gestartet. Über den weiteren Eingang 10 werden Parameter 73, welche zur Schätzung der Frequenz des Eingabetakts dienen, eingelesen und an die Kompensations-Einrichtung 16 übertragen. Aus diesen Parametern und der Soll-Ausgabetakt-Frequenz N_{a,soll} wird von der Kompensations-Einrichtung 16 eine Vorkompensation des Ausgabetakts berechnet und an den Addierer 18 geleitet. Die Summe aus der Größe ΔNₐ (k) und der Größe N_{a,soll} bzw. der Vorkompensation ist die Größe Nₐ(k), welche den digitalen Taktgenerator 19 ansteuert.

In Fig. 3 werden beispielhafte Verläufe der Füllstandsabweichung ohne Vorkompensation des Ausgabetakts dargestellt. Dies entspricht der Stellung S0 des Schalters 17 aus Fig. 2. Wie deutlich erkennbar, führt eine lediglich sehr schwache Begrenzung der Veränderung des Ausgabetakts von ΔNₘₐₓ = 10⁻² zu einer stabilen Regelung. So verläuft die Kurve 40 nach einer Einschwingphase entlang der Null-Linie der Abweichung des Füllstands des Puffers 29 von seinem Soll. Bereits eine Verengung der Begrenzung auf ΔNₘₐₓ = 10⁻³ führt, wie in Kurve 41 dargestellt, zu einer instabilen Regelung. Die Kurve 41 divergiert mit fortschreitender Zeit zunehmend weiter von der Nulllinie. Eine stärkere Begrenzung auf ΔNₘₐₓ = 10⁻⁴ führt, wie in Kurve 42 dargestellt, zu einer noch stärkeren Divergenz von der Nulllinie.

Fig. 4 zeigt beispielhafte Verläufe der Füllstandsabweichung mit Vorkompensation des Ausgabetakts. Dies entspricht der Stellung S1 des Schalters 17 aus Fig. 2. Eine schwache Begrenzung auf ΔNₘₐₓ = 10⁻² führt hier ebenfalls auf eine stabile Regelung des Füllstandes des Puffers 29. Deutlich erkennbar ist die signifikant reduzierte Einschwingzeit der Regelung bereits bei dieser schwachen Begrenzung anhand der zugehörigen Kurve 50. Auch eine Begrenzung auf ΔNₘₐₓ = 10⁻³ führt zu einer stabilen Regelung. Wie anhand der Kurve 51 ersichtlich, ist die Einschwingzeit auch hier deutlich geringer als die Einschwingzeit der stabilen Regelung aus Fig. 3. Ebenfalls erkennbar ist jedoch, dass die Einschwingzeit bereits deutlich größer ist, als bei schwächerer Beschränkung der Veränderung des Ausgabetakts pro Regelungszyklus. Selbst bei einer Beschränkung auf ΔNₘₐₓ = 10⁻⁴ kommt noch immer eine stabile Regelung zustande, wenn auch mit sehr langer Einschwingzeit. Dies ist deutlich an der Kurve 52 ersichtlich.

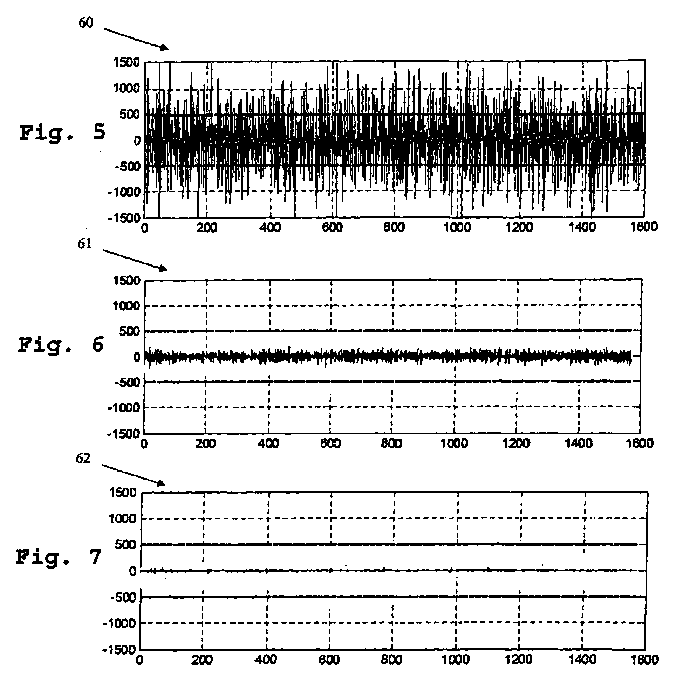

In Fig. 5 werden beispielhafte Schwankungen des Ausgabetaktes bei hohem Schätzfehler dargestellt. Dabei sind die Abweichung der zeitlichen Position des Ausgabetakts von einem idealen Ausgabetakt in y-Richtung und der zeitliche Verlauf des Messwerts in x-Richtung aufgetragen. Bei fester Begrenzung ΔNₘₐₓ = 10⁻⁴ ergibt sich für eine mittlere Standardabweichung von σ_{ε} = 10⁻⁴ des Schätzwerts von dem korrekten Wert, also einem großen Schätzfehler, eine großen Schwankung des Ausgabetakts.

Fig. 6 zeigt beispielhafte Schwankungen des Ausgabetaktes bei mittlerem Schätzfehler. Bei einer mittleren Standardabweichung von σ_{ε} = 10⁻⁵ des Schätzwerts von dem korrekten Wert, also einem mittleren Schätzfehler, ergibt sich bereits eine verhältnismäßig geringe Schwankung des Ausgabetakts.

In Fig. 7 wird beispielhafte Schwankungen des Ausgabetaktes bei geringem Schätzfehler dargestellt. Bei einer geringen Standardabweichung σ_{ε} = 10⁻⁶ des Schätzwerts von dem korrekten Wert, also einem geringen Schätzfehler, ergibt sich eine sehr geringe Schwankung des Ausgabetakts. Es wird deutlich, dass die Schwankung des Ausgabetakts hauptsächlich von dem Schätzfehler der Grobschätzung abhängt.

Die Erfindung ist nicht auf das dargestellte Ausführungsbeispiel beschränkt. Wie bereits erwähnt, können Signale unterschiedlicher Kommunikationsverfahren und Kommunikationsmodi verarbeitet werden. Ebenso kann eine Vielzahl an Parametern zur Schätzung der Störgröße herangezogen werden. Alle vorstehend beschriebenen Merkmale oder in den Figuren gezeigten Merkmale sind im Rahmen der Erfindung beliebig miteinander kombinierbar.

## Patentansprüche

1. Verfahren zur Vermeidung von Schwankungen eines digital erzeugten Ausgabetakts,
wobei ein digitales Signal mit einem Eingabetakt empfangen und in einem Puffer (29) gespeichert wird,
wobei das digitale Signal aus dem Puffer (29) ausgelesen und mit dem Ausgabetakt ausgegeben wird,
wobei der Füllstand des Puffers (29) zur Regelung der Frequenz des digital erzeugten Ausgabetaktes genutzt wird und wobei die Abweichung des Eingabetakts von dem Ausgabetakt eine Störgröße der Regelung ist,
wobei eine zusätzliche Grobschätzung der Störgröße der Regelung durchgerührt wird und
wobei die zusätzliche Grobschätzung der Störgröße zur Vorkompensation des Ausgabetakts genutzt wird,
**dadurch gekennzeichnet,**
**dass** das digitale Signal aus einem analogen Übertragungssignal (70) gewonnen wird,
**dass** das analoge Übertragungssignal (70) demoduliert und decodiert wird und
**dass** als Grobschätzwerte der Störgröße der Regelung Parameter (73), welche aus der Demodulation und/oder Decodierung des analogen Übertragungssignals (70) gewonnen werden, eingesetzt werden.

2. Verfahren nach Anspruch 1,
**dadurch gekennzeichnet,**
**dass** der Wert der Änderung des Ausgabetakts durch die Regelung innerhalb eines Regelungsschritts auf einen Maximalwert begrenzt wird, und
**dass** der Maximalwert einstellbar ist.

3. Verfahren nach Anspruch 1 oder 2,
**dadurch gekennzeichnet,**
**dass** der Füllstand des Puffers (29) nicht in jedem Regelungsschritt gemessen wird.

4. Verfahren nach einem der Ansprüche 1 bis 3,
**dadurch gekennzeichnet,**
**dass** durch ein empfangenes Signals, welches einen Kommunikationsmodus anzeigt, der Eingabetakt und der Startwert der Regelung für den Ausgabetakt festgelegt werden.

5. Vorrichtung zur Vermeidung von Schwankungen eines digital erzeugten Ausgabetakts, mit einem digitalen Taktgenerator (19), einem Puffer (29), einer Füllstands-Mess-Einrichtung (28) und einem Regler (21),
wobei der Puffer (29) ein mit einem Eingabetakt empfangenes digitales Signal speichert,
wobei der Puffer (29) das digitale Signal mit einem Ausgabetakt ausgibt,
wobei die Füllstands-Mess-Einrichtung (28) den Füllstand des Puffers (29) misst,
wobei der Regler (21) den Füllstand des Puffers (29) zur Regelung der Frequenz des digital erzeugten Ausgabetaktes nutzt,
wobei die Abweichung des Eingabetakts von dem Ausgabetakt eine Störgröße der Regelung ist,
wobei die Vorrichtung weiterhin eine Kompensations-Einrichtung (16) enthält,
wobei die Kompensations-Einrichtung (16) eine zusätzliche Grobschätzung der Störgröße der Regelung durchführt, und wobei die Kompensations-Einrichtung (16) die zusätzliche Grobschätzung der Störgröße zur Vorkompensation des Ausgabetakts nutzt,
**dadurch gekennzeichnet,**
**dass** das digitale Signal aus einem analogen Übertragungssignal (70) gewonnen wird,
**dass** das analoge Übertragungssignal (70) zur Gewinnung des digitalen Signals demoduliert und decodiert wird und
**dass** die Kompensations-Einrichtung (16) die Grobschätzwerte der Störgröße der Regelung aus Parametern (73), welche aus der Demodulation und Decodierung des analogen Übertragungssignals (70) gewonnen werden, bestimmt.

6. Vorrichtung nach Anspruch 5,
**dadurch gekennzeichnet,**
**dass** die Vorrichtung weiterhin einen Begrenzer (25) enthält,
**dass** der Begrenzer (25) den Wert der Änderung des Ausgabetakts durch die Regelung innerhalb eines Regelungsschritts auf einen Maximalwert begrenzt, und dass der Maximalwert einstellbar ist.

7. Vorrichtung nach Anspruch 5 oder 6,
**dadurch gekennzeichnet,**
**dass** die Füllstands-Mess-Einrichtung (28) den Füllstand des Puffers (29) nicht in jedem Regelungsschritt misst.

8. Vorrichtung nach einem der Ansprüche 5 bis 7,
**dadurch gekennzeichnet,**
**dass** die Vorrichtung weiterhin einen Speicher (11) enthält,
**dass** das digitale Eingangssignal mit einem aus einer Mehrzahl von Kommunikationsmodi übertragen wird,
**dass** der Speicher (11) für jeden möglichen Kommunikationsmodus einen Eingabetakt und einen Startwert der Regelung für den Ausgabetakt bereithält, und
**dass** der Speicher (11) bei Empfang eines Signals, welches einen bestimmten Kommunikationsmodus anzeigt, den gespeicherten Eingabetakt an die Kompensations-Einrichtung (16) und den gespeicherten Startwert der Regelung des Ausgabetakts an den digitalen Taktgenerator (19) überträgt.

## Claims

1. Method for avoiding fluctuations in a digitally produced output clock,
wherein a digital signal is received with an input clock and is stored in a buffer (29),
wherein the digital signal is read from the buffer (29) and is output with the output clock,
wherein the filling level of the buffer (29) is used to regulate the frequency of the digitally produced output clock and wherein the discrepancy between the input clock and the output clock is a disturbance variable for the regulation,
wherein additional approximate estimation of the disturbance variable for the regulation is performed and
wherein the additional approximate estimation of the disturbance variable is used to precompensate for the output clock,
**characterized**
**in that** the digital signal is obtained from an analogue transmission signal (70),
**in that** the analogue transmission signal (70) is demodulated and decoded, and
**in that** the approximate estimate values used for the disturbance variable for the regulation are parameters (73) which are obtained from the demodulation and/or decoding of the analogue transmission signal (70).

2. Method according to Claim 1,
**characterized**
**in that** the value of the change in the output clock is limited to a maximum value by the regulation within a regulation step, and
**in that** the maximum value is adjustable.

3. Method according to Claim 1 or 2,
**characterized**
**in that** the filling level of the buffer (29) is not measured in each regulation step.

4. Method according to one of Claims 1 to 3, **characterized**
**in that** a received signal that indicates a communication mode stipulates the input clock and the starting value of the regulation for the output clock.

5. Apparatus for avoiding fluctuations in a digitally produced output clock, having a digital clock generator (19), a buffer (29), a filling level measuring device (28) and a regulator (21),
wherein the buffer (29) stores a digital signal which is received with an input clock,
wherein the buffer (29) outputs the digital signal with an output clock,
wherein the filling level measuring device (28) measures the filling level of the buffer (29),
wherein the regulator (21) uses the filling level of the buffer (29) to regulate the frequency of the digitally produced output clock,
wherein the discrepancy between the input clock and the output clock is a disturbance variable for the regulation,
wherein the apparatus also contains a compensation device (16),
wherein the compensation device (16) performs additional approximate estimation of the disturbance variable for the regulation, and
wherein the compensation device (16) uses the additional approximate estimation of the disturbance variable to precompensate for the output clock, **characterized**
**in that** the digital signal is obtained from an analogue transmission signal (70),
**in that** the analogue transmission signal (70) is demodulated and decoded in order to obtain the digital signal, and
**in that** the compensation device (16) determines the approximate estimate values of the disturbance variable for the regulation from parameters (73) which are obtained from the demodulation and decoding of the analogue transmission signal (70).

6. Apparatus according to Claim 5,
**characterized**
**in that** the apparatus also contains a limiter (25),
**in that** the limiter (25) limits the value of the change in the output clock to a maximum value by virtue of the regulation within a regulation step, and
**in that** the maximum value is adjustable.

7. Apparatus according to Claim 5 or 6,
**characterized**
**in that** the filling level measuring device (28) does not measure the filling level of the buffer (29) in each regulation step.

8. Apparatus according to one of Claims 5 to 7, **characterized**
**in that** the apparatus also contains a memory (11),
**in that** the digital input signal is transmitted using one from a plurality of communication modes,
**in that** the memory (11) holds an input clock and a starting value for the regulation for the output clock for each possible communication mode, and
**in that** the memory (11), upon receiving a signal which indicates a particular communication mode, transmits the stored input clock to the compensation device (16) and transmits the stored starting value for the regulation of the output clock to the digital clock generator (19).

## Revendications

1. Procédé pour éviter les oscillations d'une horloge de sortie générée numériquement,
dans lequel un signal numérique est reçu avec une horloge d'entrée et mémorisé dans un tampon (29),
dans lequel le signal numérique est extrait du tampon (29) et délivré avec l'horloge de sortie,
dans lequel l'état de remplissage du tampon (29) est utilisé pour le réglage de la fréquence de l'horloge de sortie générée numériquement
et dans lequel l'écart de l'horloge d'entrée est une valeur de perturbation du réglage de l'horloge de sortie,
dans lequel une estimation grossière supplémentaire de la valeur de perturbation du réglage est effectuée,
dans lequel l'évaluation grossière supplémentaire de la valeur de perturbation est utilisée pour la pré-compensation de l'horloge de sortie,
**caractérisé en ce que**
le signal numérique est obtenu à partir d'un signal de transmission analogique (70),
**en ce que** le signal de transmission analogique (70) est démodulé et décodé et
**en ce que**, en tant que valeurs d'évaluation grossière de la valeur de perturbation du réglage, des paramètres (73), qui sont obtenus à partir de la démodulation et/ou du décodage du signal de transmission analogique (70), sont utilisés.

2. Procédé selon la revendication 1, **caractérisé en ce que**
la valeur du changement de l'horloge de sortie est limitée à une valeur maximale par le réglage lors d'une étape de réglage, et
**en ce que** la valeur maximale peut être réglée.

3. Procédé selon la revendication 1 ou 2, **caractérisé en ce que**
l'état de remplissage du tampon (29) n'est pas mesuré dans chaque étape de réglage.

4. Procédé selon l'une des revendications 1 à 3, **caractérisé en ce que**
l'horloge d'entrée et la valeur de début du réglage pour l'horloge de sortie sont déterminées par un signal reçu, qui annonce un mode de communication.

5. Dispositif pour éviter les oscillations d'une horloge de sortie générée numériquement, comportant un générateur d'horloge numérique (19), un tampon (29), un dispositif de mesure d'état de remplissage (28) et un régulateur (21),
dans lequel le tampon (29) mémorise un signal numérique reçu avec une horloge d'entrée,
dans lequel le tampon (29) délivre le signal numérique avec une horloge de sortie,
dans lequel le dispositif de mesure d'état de remplissage (28) mesure l'état de remplissage du tampon (29),
dans lequel le régulateur (21) utilise l'état de remplissage du tampon (29) pour le réglage de la fréquence de l'horloge de sortie générée numériquement,
dans lequel l'écart de l'horloge d'entrée de l'horloge de sortie est une valeur de perturbation du réglage,
dans lequel le dispositif comporte en outre un dispositif de compensation (16),
dans lequel le dispositif de compensation (16) effectue une évaluation grossière supplémentaire de la valeur de perturbation du réglage, et
dans lequel le dispositif de compensation (16) utilise l'évaluation grossière supplémentaire de la valeur de perturbation pour la pré-compensation de l'horloge de sortie,
**caractérisé en ce que**
le signal numérique est obtenu à partir d'un signal de transmission analogique (70),
**en ce que** le signal de transmission analogique (70) est démodulé et décodé pour obtenir le signal numérique et
**en ce que** le dispositif de compensation (16) détermine les valeurs d'évaluation grossière de la valeur de perturbation du réglage à partir de paramètres (73), qui sont obtenus à partir de la démodulation et du décodage du signal de transmission analogique (70).

6. Dispositif selon la revendication 5, **caractérisé en ce que**
le dispositif comporte en outre un limiteur (25),
**en ce que** le limiteur (25) limite la valeur du changement de l'horloge de sortie à une valeur maximale par le réglage lors d'une étape de réglage, et
**en ce que** la valeur maximale peut être réglée.

7. Dispositif selon la revendication 5 ou 6, **caractérisé en ce que**
le dispositif de mesure d'état de remplissage (28) ne mesure pas à chaque étape de réglage l'état de remplissage du tampon (29).

8. Dispositif selon l'une des revendications 5 à 7, **caractérisé en ce que**
le dispositif comporte en outre une mémoire (11),
**en ce que** le signal d'entrée est transmis avec l'un d'une pluralité de modes de communication,
**en ce que** la mémoire (11) dispose d'une horloge d'entrée pour chaque mode de communication possible et d'une valeur de début de réglage pour l'horloge de sortie, et
**en ce que** la mémoire (11), lors de la réception d'un signal, qui annonce un mode de communication défini, transmet l'horloge d'entrée mémorisée au dispositif de compensation (16) et la valeur de début de réglage de l'horloge de sortie mémorisée au générateur d'horloge numérique (19).
